# EUROPEAN PATENT APPLICATION

(11) **EP 4 425 741 A1**
(43) Date of publication of application: **04.09.2024**
(21) Application number: 23837938.2
(22) Date of filing: 17.05.2023
(51) Int. Cl.: H02J 7/00, B60L 3/00, B60L 50/60, B60L 58/16, B60W 20/00, G06Q 10/30, H01M 10/42

(54) **SECONDARY BATTERY INFORMATION OUTPUT SYSTEM**

(30) Priority: 14.07.2022 JP 2022113502
(71) Applicant: Toyo System Co., Ltd., Iwaki-shi, Fukushima 972-8316 (JP)
(72) Inventor: SHOJI, Hideki, Iwaki-shi, Fukushima 972-8316 (JP); TANNO, Satoshi, Iwaki-shi, Fukushima 972-8316 (JP)
(74) Representative: Schön, Christoph
(86) International application number: PCT/JP2023/018434
(87) International publication number: WO 2024/014113

(57) **Abstract**

The present invention provides a secondary battery information output system capable of effectively outputting information on a secondary battery used by a user. The secondary battery information output system according to the present invention outputs, to an output interface, prescribed information based on the result of comparison between the deterioration rate of a secondary battery, which is used by a user, at a certain time point that is determined according to the time series of index values of the deterioration state of the secondary battery, and an estimated deterioration rate, which is an estimated deterioration rate in a scheduled usage period of time of the secondary battery.

## Description

### Technical Field

The present invention relates to a system that outputs information on a secondary battery.

### Background Art

The inventors have acquired a patent for a vehicle sales system (refer to Patent Literature 1). According to the invention of Patent Literature 1, the degree of deterioration of a drive battery mounted on a vehicle is recognized on a regular or irregular basis. This vehicle is a vehicle that has been sold to a vehicle user under the condition that the vehicle, the drive battery of which has a predetermined degree of deterioration, will be returned to and repurchased by a vehicle seller after a predetermined period of time.

Further, when the degree of deterioration of the drive battery approaches, by a predetermined degree, the predetermined degree of deterioration included in the conditions at the time of sale of the vehicle, or when the degree of deterioration reaches the predetermined degree of deterioration, information is output that prompts the vehicle user to return the vehicle to the vehicle seller.

With this arrangement, the vehicle user is prompted to return the vehicle when a predetermined state of deterioration is approaching, or the like, thus increasing the possibility that the vehicle can be returned with the drive battery in a predetermined deterioration state installed therein. This enables the vehicle user to use the vehicle provided with the drive battery with a high sense of security.

### Citation List

### Patent Literature

Patent Literature 1: Japanese Patent No. 6788296

### Summary of Invention

### Technical Problem

In the case where a secondary battery is used as the power supply source of electrically powered equipment, the increase in the degree of deterioration of the secondary battery significantly varies depending on how the electrically powered equipment is used. However, a user of the electrically powered equipment does not necessarily have accurate knowledge about the manner of using the equipment that will cause progress of deterioration of the secondary battery installed in the equipment, or the manner that makes it possible to continue to use the equipment without causing much progress of the deterioration. For this reason, it is conceivable that the user may unintentionally continue to use the equipment in a manner that accelerates the deterioration of the secondary battery, and may be forced to replace the secondary batteries earlier than scheduled.

Therefore, if a user is using equipment in a way that accelerates the deterioration of a secondary battery, it is desirably possible to output information that informs the user of this fact before the deterioration of the secondary battery actually progresses. This is because, by doing so, the possibility will increase that the user can continue to use the secondary battery without causing much progress of the deterioration of the secondary battery.

However, according to the invention of Patent Literature 1, the vehicle user is prompted to return the vehicle when the predetermined degree of deterioration has approached a predetermined degree of deterioration to a predetermined extent or when the degree of deterioration has reached the predetermined degree of deterioration, so that the secondary battery is in a state in which the deterioration of the secondary battery has already progressed to a certain degree at that moment. This has not been effective enough to increase the possibility that the user can continue to use the secondary battery without causing much progress of the deterioration of the secondary battery.

Therefore, an object of the present invention is to provide a secondary battery information output system capable of effectively outputting information on the deterioration state of a secondary battery used by a user.

### Solution to Problem

A secondary battery information output system according to the present invention
outputs, to an output interface, prescribed information based on a result of comparison between a deterioration rate of a secondary battery at a certain time point that is determined according to a time series of index values of a deterioration state of the secondary battery used by a user and an estimated deterioration rate, which is an estimated deterioration rate in a scheduled usage period of time of the secondary battery.

According to the present invention, the information based on the result of comparison between the deterioration rate of the secondary battery used by the user and the estimated deterioration rate of the secondary battery is output to the output interface.

With this arrangement, if, for example, the deterioration rate of a secondary battery being used is faster than an estimated deterioration rate that is estimated in advance, or if, for example, the deterioration rate is slower than the estimated deterioration that is estimated in advance, then the information to this effect can be provided to a user.

This arrangement also increases the possibility that the user can continue to use the secondary battery without causing much progress of the deterioration of the secondary battery.

Thus, the present invention makes it possible to effectively output information related to the deterioration state of a secondary battery used by a user.

A business of buying and selling used secondary batteries for reuse rather than disposing thereof is spreading. A user of a secondary battery can use the money earned by selling the used secondary battery rather than disposing thereof to purchase, for example, a new secondary battery. In this case, it would be further desirable for the user if the possibility of selling the used secondary battery at a user's desired price could be increased.

Preferably, in the secondary battery information output system according to the present invention,
the estimated deterioration rate is a deterioration rate below which the deterioration rate of the secondary battery should be for selling the secondary battery at a desired sale price asked by the user after being used until a scheduled time point determined in advance, and
the prescribed information output in the case where the deterioration rate of the secondary battery is equal to or more than the estimated deterioration rate includes information for prompting usage based on a usage method for slowing down the deterioration rate of the secondary battery, or information prompting sale of the secondary battery before the scheduled time point.

According to the present invention, if the deterioration rate of a secondary battery is equal to or more than an estimated deterioration rate, then information for prompting use based on a usage method for slowing down the deterioration rate of the secondary battery, or information prompting sale of the secondary battery before the scheduled time point is output. The estimated deterioration rate is a deterioration rate, below which the deterioration rate of the secondary battery should be for selling the secondary battery at a desired sale price asked by a user, after the secondary battery is used until a scheduled time point determined in advance.

In other words, the prescribed information having the above-described contents is determined and output according to whether the deterioration rate of a secondary battery is a deterioration rate that allows the secondary battery to be sold at an amount desired by a user himself or herself. This enables a sale at a desired sale price, thus motivating the user to use the secondary battery in such a manner as not to cause much progress of the deterioration thereof in the remaining period of time until the scheduled time point.

Or more specifically, if a user decides that it is difficult to use a secondary battery in such a manner as not to cause much progress of the deterioration of the secondary battery, then the user will sell the secondary battery earlier than a scheduled time point, thus increasing the certainty that the user can sell the secondary battery at a desired sale price.

As described above, according to the present invention, it is possible to increase the likelihood that a user can sell a used secondary battery at a price desired by the user.

Preferably, in the secondary battery information output system according to the present invention,
the deterioration rate of the secondary battery at the certain time point is determined by a first approximation curve representing a time series of the deterioration states of the secondary battery based on the time series of the index values,
the estimated deterioration rate is determined by a second approximation curve representing an estimated tendency of the progress of deterioration state of the secondary battery with passage of time during the scheduled usage period of time, and
contents of the prescribed information are determined on the basis of a result of comparison between a rate of change of the first approximation curve at the certain time point and a rate of change of the second approximation curve at a time point corresponding to the certain time point.

According to the present invention, the prescribed information is output, the prescribed information being determined according to a result of comparison between specific pieces of information, i.e., the rate of change of the first approximation curve at the certain time point, which determines the deterioration rate of a secondary battery, and the rate of change of the second approximation curve at a time point corresponding to the certain time point, which determines the estimated deterioration rate of the secondary battery.

This increases the user's sense of satisfaction with the output information, consequently further increasing the possibility that the user can continue using the secondary battery without causing much progress of the deterioration of the secondary battery.

In addition, businesses engaged in buying and selling not only used secondary batteries alone, but also entire electrically powered equipment provided with secondary batteries for reuse, are spreading. A user of electrically powered equipment can use the money earned by selling the used electrically powered equipment, including the installed secondary battery, to purchase, for example, new electrically powered equipment.

In particular, the selling price of a vehicle driven by electric power, such as a hybrid vehicle or an electric vehicle, includes not only the price of the vehicle body but also the price of a drive battery. Therefore, the sale prices of these vehicles are higher than those of general engine vehicles, thus placing a large burden on users of these vehicles at the time of purchase. If users of used hybrid vehicles or electric vehicles or the like can use the money earned from selling these vehicles to purchase new vehicles, it will be possible to reduce the financial burden on users when purchasing vehicles driven by electric power, and also to contribute to the spread of these vehicles.

In this case, it would be more desirable if the user could be informed of how much electrically powered equipment in use can be sold for, because this would give the user an opportunity to decide a timing at which the electrically powered equipment in use should be sold.

Preferably, in the secondary battery information output system according to the present invention,
the secondary battery is installed in electrically powered equipment,
the electrically powered equipment is electrically powered equipment which is provided with the secondary battery and has been sold to the user under the condition that a seller of the electrically powered equipment will repurchase the electrically powered equipment at the scheduled time point, and
the prescribed information output in the case where a deterioration rate at the certain time point is equal to or more than the estimated deterioration rate includes information on an estimated price at the time of repurchasing the electrically powered equipment, which is determined according to the deterioration rate of the secondary battery at the time point.

Further, in the secondary battery information output system according to the present invention,
the electrically powered equipment may be a hybrid vehicle or an electric vehicle.

According to the present invention, the information on an estimated price at the time of repurchasing, which is determined according to the deterioration rate of a secondary battery installed in electrically powered equipment, is output for the electrically powered equipment sold to a user under the condition that a seller of the electrically powered equipment including a hybrid vehicle or an electric vehicle will repurchase.

This allows users of electrically powered equipment to be informed of how much the electrically powered equipment in use can be sold for. Further, the prices at the time of repurchasing the electrically powered equipment are the prices estimated by taking into account specific information such as the deterioration rates of the secondary batteries, thus making it possible to increase the user's sense of satisfaction with the output information. This, in turn, will motivate users to use electrically powered equipment in such a manner as not to cause much progress of the deterioration of secondary batteries, thereby accordingly increasing the amount of money that the users of the electrically powered equipment can earn from the sales of their used electrically powered equipment and also increasing the possibility of allocating more money to the purchase of new electrically powered equipment.

### Brief Description of Drawings

FIG. 1 is a block diagram illustrating an example of the overall view of a secondary battery information output system in accordance with the present invention.
FIG. 2 is a chart illustrating an example of the processing details of the secondary battery information output system in accordance with the present invention.
FIG. 3 is a flowchart illustrating an example of the processing details of the secondary battery information output system in accordance with the present invention.
FIG. 4 is another flowchart illustrating an example of the processing details of the secondary battery information output system in accordance with the present invention.
FIG. 5 is a conceptual diagram illustrating an example of the processing details of the secondary battery information output system in accordance with the present invention.
FIG. 6 is another conceptual diagram illustrating an example of the processing details of the secondary battery information output system in accordance with the present invention.
FIG. 7 is a flowchart illustrating an example of the processing details of the secondary battery information output system in accordance with the present invention.
FIG. 8 is a conceptual diagram illustrating a modified example of the processing details of the secondary battery information output system in accordance with the present invention.
FIG. 9 is a conceptual diagram illustrating another modified example of the processing details of the secondary battery information output system in accordance with the present invention.

### Description of Embodiments

### <Configuration of a secondary battery information output system>

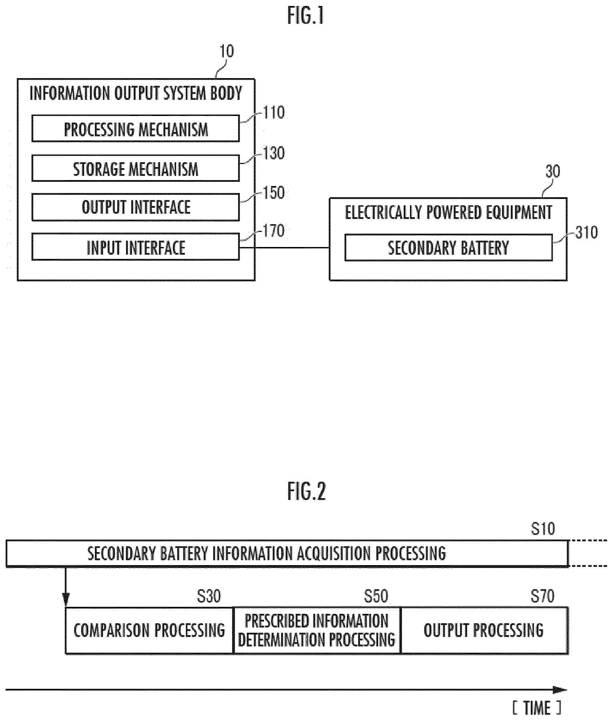

Referring first to FIG. 1, the configuration of a secondary battery information output system according to the present embodiment will be described. The same components will be assigned the same reference numerals, and the descriptions thereof may be omitted.

An information output system body 10 for a secondary battery according to the present embodiment is a computer system configured by including, for example, a processing mechanism 110, a storage mechanism 130, an output interface 150, and an input interface 170.

The processing mechanism 110 is composed of an arithmetic processing device such as a CPU (Central Processing Unit), a memory, and I/O (Input/Output) devices, and the like. The processing mechanism 110 may be composed of one processor, or may be composed of a plurality of processors that can communicate with each other. The processing mechanism 110 reads a predetermined program from, for example, the storage mechanism 130 and executes the predetermined program thereby to execute each processing, which will be described later.

The processing mechanism 110 causes the output interface 150 to output prescribed information based on a result of comparison between a deterioration rate of a secondary battery 310 at a certain time point determined according to the time series of index values of the deterioration state of the secondary battery 310 used by a user, and an estimated deterioration rate, which is an estimated deterioration rate in a scheduled usage period of time of the secondary battery 310.

The processing mechanism 110 may be configured so as to generate prescribed information by itself and to cause the output interface 150 to output the prescribed information, or information generated by an external computer (not illustrated) or the like may be accepted via the input interface 170, and then a part or all of the prescribed information may be used and output through the output interface 150.

The storage mechanism 130 is composed of a storage device such as, for example, a ROM (Read Only Memory), a RAM (Random Access Memory), and an HDD (Hard Disk Drive) to store information necessary for processing performed by the processing mechanism 110, processing results, and the like.

More specifically, if the configuration is such that, for example, the processing mechanism 110 itself generates prescribed information and causes the output interface 150 to output the generated prescribed information, then the storage mechanism 130 stores the time series of the index values of the deterioration state of the secondary battery 310, the information on the first approximation curve, the information on the second approximation curve, and the like.

Alternatively, if a part or all of prescribed information is generated by an external computer or the like (not illustrated), then the part or all of the information is stored in the external computer.

The output interface 150 is a display device that outputs, for example, prescribed information by displaying the prescribed information in the form of characters or images, or the like. Alternatively, the output interface 150 may be, for example, a speaker that outputs prescribed information as sound, or a vibrator that outputs prescribed information as vibration.

The input interface 170 is a communication mechanism that accepts input of information necessary for the processing performed by the information output system, and may be composed by including, for example, a keyboard, a mouse, a touchpad, or a touch panel, and other pointing devices, as necessary.

The input interface 170 is, for example, connected to electrically powered equipment 30, as illustrated in FIG. 1, to accept input of information necessary for processing performed by the information output system from the secondary battery 310 installed in the electrically powered equipment 30. The information necessary for the processing performed by the information output system is, for example, the information on the index values of the deterioration state of the secondary battery 310 used by a user.

Further, the index values of the deterioration state of the secondary battery 310 are, for example, the increasing rate or the increasing amount of an internal resistance value of the secondary battery 310 with respect to an initial internal resistance value, the decreasing rate or the decreasing amount of a discharge capacity with respect to an initial discharge capacity, the decreasing rate or the decreasing amount of SOH (State Of Health), and the decreasing rate or the decreasing amount of charge/discharge efficiency, which is a value of the ratio of a discharge capacity to a charge capacity, but are not limited thereto.

The electrically powered equipment 30 may be, for example, a vehicle driven by electric power, a stationary power supply system, and various other types of equipment operated by electric power supplied from the secondary battery 310.

The secondary battery 310 installed in the electrically powered equipment 30 is, for example, a lithium-ion battery, but may be any battery that can be repeatedly used as a power source by repeatedly charging and discharging, such as a nickel cadmium battery or a lead battery.

### <Overview of Processing>

A description will now be given of the processing details of the information output system according to the present embodiment. Referring first to FIG. 2, the flow of the series of processing performed by the information output system according to the present embodiment will be described. FIG. 2 is a chart illustrating the flow of processing performed by the information output system. The information output system repeatedly executes, while the secondary battery 310 is being used, secondary battery information acquisition processing (S10 in FIG. 2) on a regular or irregular basis to acquire the time series of the index values of the deterioration state of the secondary battery 310 used by a user.

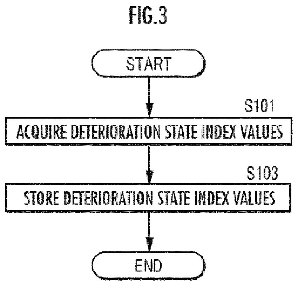

Then, the information output system performs comparison processing (S30 in FIG. 2), prescribed information determination processing (S50 in FIG. 2), and output processing (S70 in FIG. 2) thereby to output the prescribed information on a regular or irregular basis or in response to a user operation for requesting the output of prescribed information. The following will describe the details of each processing with reference to FIG. 3 to FIG. 7.

### <Secondary battery information acquisition processing>

In the secondary battery information acquisition processing, the processing mechanism 110 acquires the index values of the deterioration state of the secondary battery 310 used by a user (S101 in FIG. 3). The processing mechanism 110 first acquires the information on, for example, the current value, the voltage value, and an ambient temperature of the secondary battery 310 as the information that provides the source of the index values of the deterioration state of the secondary battery 310, and also acquires information required to determine the index values of the deterioration state of the secondary battery 310.

The information on the current value, the voltage value, and the ambient temperature of the secondary battery 310 is acquired using well-known sensors such as, for example, an ammeter, a voltmeter, and a thermometer, respectively. The processing mechanism 110 accepts the input of such information via the input interface 170.

Alternatively, the processing mechanism 110 may accept the input of the information, which has been separately acquired using the sensors or the like, by reading the information from a storage medium via the input interface 170, or may accept the input by receiving the information via wired or wireless communication from an external computer (not illustrated).

Then, based on the information acquired as described above, the processing mechanism 110 acquires the increasing rate of the internal resistance value, the value of SOH, and the like, which are the index values of the deterioration state of the secondary battery 310.

The deterioration index values of the secondary battery 310 may be determined using a correspondence table showing the correspondence relationship between the information on, for example, current values, voltage values, and ambient temperatures (any of the information may be omitted as necessary; the same will apply hereinafter.) and the deterioration index values, and may also be determined using any of a variety of methods such as functions, calculation formulas, and learned models that use the information on current values, voltage values, and ambient temperatures as inputs and use deterioration index values as outputs.

Then, the processing mechanism 110 stores the acquired index values of the deterioration state in the storage mechanism 130 in a time series manner (S103 in FIG. 3). The time series of the index values of the deterioration state of the secondary battery 310 used by the user is acquired by repeating the processing on a regular or irregular basis.

The information that provides the source of the index value of the deterioration state of the secondary battery 310 may include information on the usage state of the secondary battery 310, which affects the deterioration state of the secondary battery 310.

If the electrically powered equipment 30 is a vehicle driven by electric power, such as a hybrid vehicle or an electric vehicle (including a two-wheeled vehicle, a fourwheeled vehicle, and various other types of vehicles; the same will apply hereinafter.), then the information on the usage state includes, for example, how the brake or accelerator is depressed, which gear the vehicle is in, the speed, the orientation in the XYZ directions, the position, the altitude, whether an air conditioner is operating and temperature setting, the number of times of charging and discharging, and the number of times or percentage of a quick charge has been performed out of charging operations. Alternatively, if the electrically powered equipment 30 is, for example, a stationary power supply system, then the information on the usage state may include environmental temperature, humidity, meteorological information, position, vibration, and the like. These pieces of information are acquired using various well-known sensors or the like.

### <Comparison processing>

The comparison processing is processing for comparing a deterioration rate of the secondary battery 310 at a certain time point, which is determined according to the time series of the index values of a deterioration state, and an estimated deterioration rate, which is an estimated deterioration rate in a scheduled usage period of time of the secondary battery 310. The scheduled usage period of time of the secondary battery 310 is a period of time from the user's purchase of the secondary battery 310 to the moment at which the use of the secondary battery 310 is scheduled to end, and the length of the scheduled period of time may be arbitrarily set to, for example, three years, by a user or a seller, or the like of the secondary battery 310.

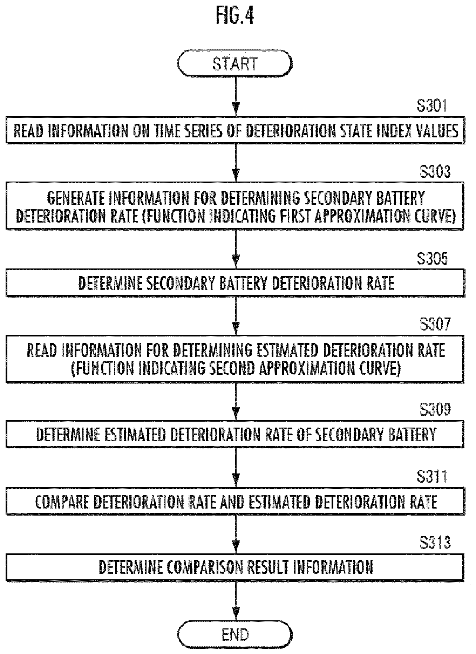

When the processing is begun, the processing mechanism 110 reads information on the time series of the index values of the deterioration state of the secondary battery 310 used by a user, which is stored in the storage mechanism 130 (S301 in FIG. 4). At this time, the processing mechanism 110 may read all the past information among the information on the time series of the index values of the deterioration state of the secondary battery 310 stored in the storage mechanism 130, or may read, for example, most recent information or information in a predetermined period of time such as specific several months, weeks, days, and hours.

Then, the processing mechanism 110 generates information for determining the deterioration rate of the secondary battery 310 at a certain time point by using the information on the time series of the index values of the deterioration state of the secondary battery 310 that has been read as described above (S303 in FIG. 4).

The processing mechanism 110 generates a function indicating an approximation curve representing the time series of the deterioration state of the secondary battery 310 (the first approximation curve) by using, for example, the information on the time series of the index values of the deterioration state of the secondary battery 310 as the information for determining the deterioration rate of the secondary battery 310 at a certain time point.

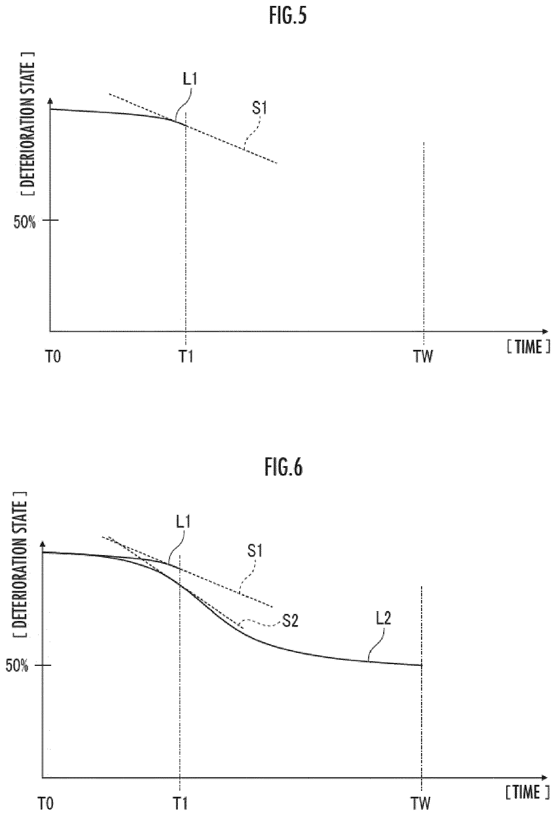

FIG. 5 is a conceptual diagram illustrating the processing details of the comparison processing. FIG. 5 illustrates a first approximation curve L1 represented by the function generated on the basis of the information on the time series of the index values of the deterioration state of the secondary battery 310 in a period of time from a time point T0, at which the usage of the secondary battery 310 is started, to a first time point T1. The vertical axis in FIG. 5 denotes the deterioration state of the secondary battery 310, with the upper side showing a less advanced deterioration state and the lower side showing a more advanced deterioration state. The horizontal axis denotes the passage of time. Further, the period of time from the usage start time point T0 to a scheduled usage end time point TW is the scheduled usage period of time of the secondary battery 310.

The approximation curve includes not only the smooth curve as illustrated in FIG. 5, but also a polygonal line and a straight line (the same will apply hereinafter).

Then, the processing mechanism 110 uses the first approximation curve L1 obtained as described above so as to calculate the change rate of the first approximation curve L1 at the time point at which the deterioration rate is to be determined. More specifically, the change rate of the first approximation curve L1 is a time derivative value at the time point of the first approximation curve L1, i.e., the value of the inclination of the first approximation curve L1 at that particular time point. The processing mechanism 110 determines the inclination of the first approximation curve L1 obtained as described above as the deterioration rate of the secondary battery 310 (S305 in FIG. 4).

FIG. 5 illustrates a state in which the inclination at the first time point T1 of the first approximation curve L1 has been defined as the deterioration rate and a line S1 denoting the inclination of the first approximation curve L1 at the first time point T1 has been obtained.

The processing mechanism 110 may use the value of the inclination of the approximation curve at one time point (e.g., T1) to determine the deterioration rate of the secondary battery 310, or may use the values of the inclinations of the approximation curve at a plurality of time points (T1 may be included or excluded) to determine the deterioration rate of the secondary battery 310. In other words, for example, after calculating the inclination values of the approximation curve at the plurality of predetermined time points, from among these values, the value at the time point of a steepest inclination, the value at the time point of a gentlest inclination, the value at the time point indicating the median value of the inclination, or the value of the inclination at the time point indicating the average value of the inclination may be determined as the deterioration rate of the secondary battery 310.

Thus, "the certain time point" may be a time point determined in advance in the period of time during which the index values of the deterioration state of the secondary battery 310 used by the user have been acquired. Alternatively, the certain time point can be, for example, an arbitrary time point that is determined by a user or a seller of the secondary battery 310 and input via an input interface. The arbitrary time point may be one year or several months before the scheduled usage end time point TW, or any other time point that is a predetermined period of time back from the scheduled usage end time point TW.

Subsequently, the processing mechanism 110 reads, for example, the information that determines the estimated deterioration rate of the secondary battery 310 in a scheduled usage period of time from the storage mechanism 130 (S307 in FIG. 4). The information read by the processing mechanism 110 at this time is, for example, the information on a function that indicates an approximation curve (the second approximation curve) representing an expected tendency of the progress of the deterioration state of the secondary battery 310 with the passage of time in the scheduled usage period of time of the secondary battery 310.

FIG. 6 is a conceptual diagram illustrating the processing details of the comparison processing. FIG. 6 illustrates a state in which a second approximation curve L2 is overlapped with the first approximation curve L1. The second approximation curve L2 indicates the height of the estimated deterioration state of the secondary battery 310 at each time point in the scheduled usage period of time and also the estimated deterioration rate at each time point.

The second approximation curve L2 is determined by, for example, collecting and analyzing the time series of the index values of the degradation states of a plurality of secondary batteries 310 that are the same as, the same type as, or similar to the secondary battery 310 to be subj ected to the processing, and then stored in the storage mechanism 130 in advance. Alternatively, the second approximation curve L2 may be determined by, for example, the empirical rule of a manufacturer, a seller, or a user of the secondary battery 310.

Subsequently, the processing mechanism 110 uses the second approximation curve L2 to calculate the change rate of the second approximation curve L2 at a time point corresponding to the "certain time point" mentioned above. At this time, the processing mechanism 110 calculates the change rate of the second approximation curve L2 at a time point corresponding to the certain time point by using the same method as that for calculating, from the first approximation curve L1, the change rate of the first approximation curve L1 at a time point at which the deterioration rate is to be determined. The processing mechanism 110 determines, as the estimated deterioration rate, the change rate of the second approximation curve L2 obtained as described above (S309 in FIG. 4).

FIG. 6 illustrates a state in which the inclination at the first time point T1 of the second approximation curve L2 has been defined as the deterioration rate, and a line S2 representing the inclination of the second approximation curve L2 at the first time point T1 has been obtained.

Thereafter, the processing mechanism 110 compares the deterioration rate of the secondary battery 310 at the certain point obtained as described above and the estimated deterioration rate at a time point corresponding to the certain point (S311 at FIG. 4). In other words, the processing mechanism 110 compares the magnitude of the inclination indicated by the line S1 representing the inclination of the first approximation curve L1 at the first time point T1 and the magnitude of the inclination indicated by the line S2 representing the inclination of the second approximation curve L2 at the first time point T1. The result of the comparison given by the processing mechanism 110 is represented as, for example, the difference between the value indicating the magnitude of the inclination of the first approximation curve L1 at the first time point T1 and the value indicating the magnitude of the inclination of the second approximation curve L2 at the first time point T1, or the ratio between these values (the ratio of the latter to the former).

In the example illustrated in FIG. 6, the inclination indicated by the line S1 representing the inclination of the first approximation curve L1 at the first time point T1 is gentler than the inclination indicated by the line S2 representing the inclination of the second approximation curve L2 at the first time point T1, meaning that the deterioration rate of the secondary battery 310 at the first time point T1 is slower than the estimated deterioration rate.

Based on, for example, the comparison result, the processing mechanism 110 determines the information on the result of the comparison between the deterioration rate and the estimated deterioration rate, such as whether the deterioration rate of the secondary battery 310 is faster or slower than the estimated deterioration rate, and the degree of the difference in rate (e.g., faster or slower by what percentage) (S313 in FIG. 4), and terminates the comparison processing.

### <Prescribed information determination processing>

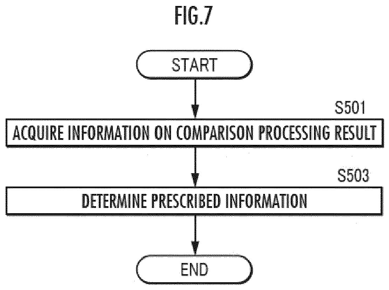

Upon a start of the processing, the processing mechanism 110 acquires the information on the result of the comparison processing (S501 in FIG. 7), and determines prescribed information based on the acquired information (S503 in FIG. 7). If the acquired information on the comparison result is "slower than the estimated deterioration rate," then the processing mechanism 110 determines, as the prescribed information, the information indicating that the deterioration rate is slower than the estimated deterioration rate. Alternatively, based on the read comparison result, the processing mechanism 110 determines, as the prescribed information, the information indicating "faster than the estimated deterioration rate," "approximately the same as the estimated rate (e.g., within a difference of 2 to 5%)," "faster (or slower) than the estimated rate by what percentage," or "the inclination is larger (or smaller) than the inclination of the estimated rate by 1). Alternatively, the processing mechanism 110 may be configured to determine, as the prescribed information, each of the deterioration rate and the estimated deterioration rate of the secondary battery 310 by using the information indicating the correspondence relationship between the rates and the levels or the like indicating the rates (e.g., levels 1 to 5).

The processing mechanism 110 may be configured to determine that the deterioration rate is above (or below) an estimated deterioration rate if, for example, the deterioration rate is even slightly above (or below) the estimated deterioration rate, or may be configured to have some flexibility for such determination. More specifically, the processing mechanism 110 may be configured to determine, for example, whether the extent to which the deterioration rate exceeds the estimated deterioration rate falls within a predetermined tolerance range (such as +2% of the estimated deterioration rate. The value may be arbitrarily set.), and determine that the deterioration rate does not exceed the estimated deterioration rate if it is determined that the extent falls within the tolerance range.

### <Output processing>

Upon a start of the processing, the processing mechanism 110 recognizes the prescribed information determined by the prescribed information determination processing, outputs the recognized prescribed information to, for example, a display, which is the output interface 150, and terminates the series of processing.

The processing mechanism 110 may display, for example, a text saying "the deterioration rate of the secondary battery is faster than the estimated deterioration rate" on the display as the prescribed information, or may actually draw, for example, a graph like the one illustrated in FIG. 6 and display the graph on the display in addition to or in place of the text.

This allows a user to be informed if, for example, the deterioration rate of the secondary battery 310 in use is faster than the estimated deterioration rate that has been estimated in advance, or if, for example, the deterioration rate is slower than the estimated deterioration rate that has been estimated in advance.

This also increases the possibility that the user can continue to use the secondary battery 310 without causing much progress of the deterioration of the secondary battery 310.

Thus, according to the present invention, the information on the deterioration state of the secondary battery 310 used by a user can be effectively output.

The above has described the flow of the processing performed by the information output system of the present embodiment; however, the present invention is not limited to the embodiment. Various changes can be made within a range not departing from the scope of the present invention. The following will describe modified embodiments of the present invention.

### <Modified embodiment 1>

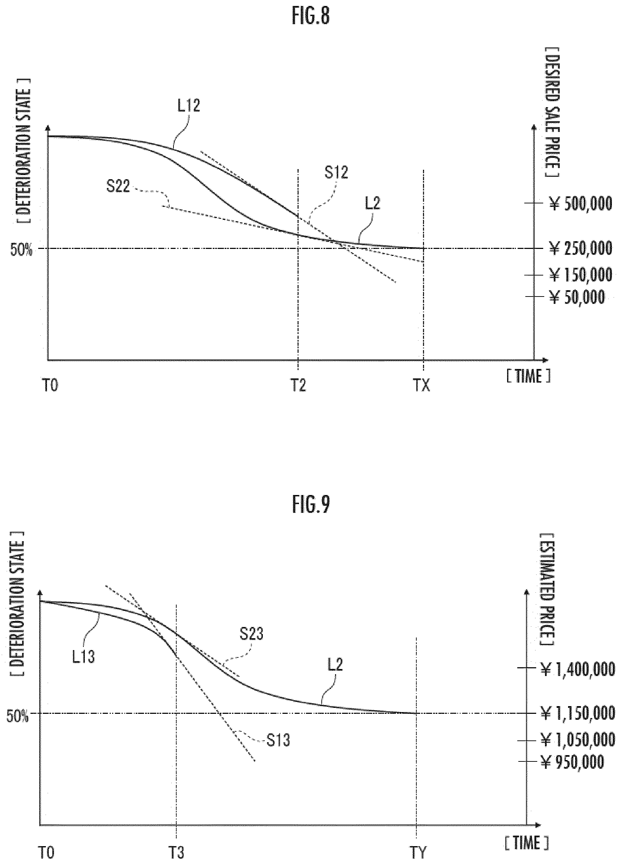

Referring to FIG. 8, modified embodiment 1 will be described. FIG. 8 is a conceptual diagram illustrating the processing details of the comparison processing in the present modified embodiment. FIG. 8 illustrates:
· First approximation curve L12 indicated by a function generated on the basis of the time series of the index values of the deterioration state of a secondary battery 310 in the period of time from a time point T0, at which the usage of the secondary battery 310 is started, to a second time point T2;
· Line S12 representing the inclination of the first approximation curve L12 at the second time point T2 that has been obtained by defining the inclination of the first approximation curve L12 at the second time point T2 as the deterioration rate;
· Second approximation curve L2; and
· Line S22 representing the inclination of the second approximation curve L2 at the second time point T2 that has been obtained by defining the inclination of the second approximation curve L2 at the second time point T2 as the deterioration rate.

Further, in the present embodiment, the estimated deterioration rate, i.e., the inclination of the second approximation curve L2 at each time point, is the deterioration rate below which the deterioration rate of the secondary battery 310 should be for selling the secondary battery 310 at a desired sale price asked by a user after using the secondary battery 310 until a scheduled time point TX determined in advance. The vertical axis on the right in FIG. 8 indicates the estimated sale price based on the deterioration state of the secondary battery 310, with the higher level indicating a state in which the secondary battery 310 can be sold at a higher price and the lower level indicating a state in which the secondary battery 310 will be sold at a lower price. In the present embodiment, the desired sale price is 250,000 yen. Further, in FIG. 8, the period of time from the usage start time point T0 to a scheduled time point TX is the scheduled usage period of time of the secondary battery 310.

In the example illustrated in FIG. 8, the inclination of the line S12 representing the inclination of the approximation curve L12 at the second time point T2 is steeper than the inclination of the line S22 representing the inclination of the second approximation curve L2 at the second time point T2, so that the deterioration rate of the secondary battery 310 at the second time point T2 is faster than the estimated deterioration rate.

In the comparison processing, the processing mechanism 110 determines that, if the current deterioration rate continues, the deterioration state of the secondary battery 310 will be below the deterioration state indicated by the second approximation curve L2, resulting in a possibility that the secondary battery 310 after being used until the scheduled time point TX cannot be sold at the desired sale price asked by the user.

In this case, in the prescribed information determination processing, the processing mechanism 110 determines, as the prescribed information, the information that prompts usage according to a usage method for slowing down the deterioration rate of the secondary battery 310 or the information that prompts selling the secondary battery 310 before the scheduled time point TX. Then, in the output processing, the prescribed information that has been determined is output for the user.

As the prescribed information, the processing mechanism 110 may display, on the display, a text saying, for example, "the deterioration of the battery is progressing fast. It is possible that the battery cannot be sold at the desired sale price (250,000 yen) after being used until the scheduled time point." and a text saying "Would you like to reconsider how you use electricity to slow down the progress of battery deterioration? " or "If you would like to sell the battery at the desired sale price (250,000 yen), we recommend that you trade in your battery earlier than scheduled." or a graph such as the one illustrated in, for example, FIG. 8, may be actually drawn in addition to the above-described texts, and displayed on the display.

In other words, depending on whether the deterioration rate of the secondary battery 310 is a deterioration rate that enables sale of the secondary battery 310 for an amount desired by the user himself/herself, prescribed information containing the above-described contents is determined and output, thus permitting sale for a desired sale price. This motivates the user to use the secondary battery 310 in a manner that does not cause much progress of the deterioration thereof during the remaining period of time until a scheduled time point.

Alternatively, if the user decides that it is difficult to use the secondary battery 310 in a manner that does not cause much progress of the deterioration thereof, then the user will sell the secondary battery 310 earlier than the scheduled time point, thus leading to higher probability that the user can sell the secondary battery 310 at a desired sale price.

In the comparison processing, the processing mechanism 110 may be configured such that, even when the deterioration rate of the secondary battery 310 at the second time point T2 is faster than the estimated deterioration rate, and the current deterioration rate is continued, if, for example, the processing mechanism 110 determines that the deterioration state of the secondary battery 310 will not become worse than the deterioration state indicated by the second approximation curve L2, the processing mechanism 110 determines, as the prescribed information, the information that replaces the information for prompting the usage according to the usage method for slowing down the deterioration rate of the secondary battery 310 or the information for prompting the sale of the secondary battery 310 before the scheduled time point.

In other words, for example, the processing mechanism 110 in this case may be configured so as to determine, as the prescribed information, the information indicating a likelihood that the secondary battery 310 can be sold at a desired sale price even if the deterioration rate of the secondary battery 310 is faster than the estimated deterioration rate and the usage is continued with that particular deterioration rate until the scheduled time point TX, and may output the prescribed information to the output interface 150.

### <Modified embodiment 2>

Referring to FIG. 9, modified embodiment 2 will be described. FIG. 9 is a conceptual diagram illustrating the processing details of the comparison processing in the present modified embodiment.

In the present embodiment, electrically powered equipment 30 is the electrically powered equipment 30 which is provided with a secondary battery 310 and has been sold to a user under the condition that a seller of the electrically powered equipment 30 will repurchase the electrically powered equipment 30 at a scheduled time point TY In particular, a case will be described in which the electrically powered equipment 30 is an electric vehicle, but the electrically powered equipment 30 may be, for example, a hybrid vehicle.

FIG. 9 illustrates:
· First approximation curve L13 indicated by a function generated on the basis of the time series of the index values of the deterioration state of the secondary battery 310 in the period of time from a time point T0, at which the usage of the secondary battery 310 is started, to a third time point T3;
· Line S13 representing the inclination of the first approximation curve L13 at the third time point T3 that has been obtained by defining the inclination of the first approximation curve L13 at the third time point T3 as the deterioration rate;
· Second approximation curve L2; and
· Line S23 representing the inclination of the second approximation curve L2 at the third time point T3 that has been obtained by defining the inclination of the second approximation curve L2 at the third time point T3 as the deterioration rate.

The vertical axis on the right in FIG. 9 indicates the estimated sale prices at the time of repurchasing an electric vehicle on the basis of the deterioration state of the secondary battery 310 mounted on the electric vehicle. A higher level indicates a state in which the electric vehicle can be sold for a higher price and a lower level indicates a state in which the electric vehicle will be sold for a lower price.

In the present embodiment, each of the estimated prices to be set is the amount obtained by adding the estimated repurchase price of the vehicle body at the scheduled time point TY (e.g., 900,000 yen), and the estimated repurchase price of the secondary battery 310 (500,000 yen to 50,000 yen depending on the deterioration state). These amounts are arbitrarily set by an electric vehicle seller or the like when, for example, the electric vehicle is sold to a user. Further, in FIG. 9, the period of time from the usage start time point T0 to the scheduled time point TY is the scheduled usage period of time of the secondary battery 310 (and the vehicle itself).

In the example illustrated in FIG. 9, the inclination of the line S13 representing the inclination of the first approximation curve L13 at the third time point T3 is steeper than the inclination of the line S23 representing the inclination of the second approximation curve L2 at the third time point T3, showing that the deterioration rate of the secondary battery 310 at the third time point T3 is faster than the estimated deterioration rate.

The processing mechanism 110 determines in the comparison processing that the deterioration rate of the secondary battery 310 at the third time point T3 is equal to or more than the estimated deterioration rate. Then, in the prescribed information determination processing, the processing mechanism 110 determines the estimated price at the time of repurchase of the electric vehicle on the basis of the deterioration rate of the secondary battery 310 at the third time point T3.

Based on, for example, the deterioration rate of the secondary battery 310 at the third time point T3, the processing mechanism 110 determines the estimated repurchase price of the secondary battery 310 according to a predetermined algorithm, and adds up the determined amount and the estimated amount of the repurchase price of the vehicle body thereby to determine the estimated price at the time of repurchasing the electric vehicle. The estimated price at the time of repurchase of the electric vehicle in the example illustrated in FIG. 9 is, for example, 950,000 yen (= 900,000 yen for the vehicle body + 50,000 yen for the secondary battery).

In this case, in the prescribed information determination processing, the processing mechanism 110 determines, as the prescribed information, the information indicating that the estimated price at the time of repurchasing the electrically powered equipment is 950,000 yen. Then, in the output processing, the prescribed information that has been determined is output for the user.

The processing mechanism 110 may display, as the prescribed information, a text saying, for example, "the deterioration is progressing fast; the estimated price at the time of repurchasing your vehicle is 950,000 yen" on a display, or may actually draw a graph such as the one illustrated in, for example, FIG. 9, in addition to or in place of the above text and display the information together with the information on the estimated price at the time of repurchasing the electrically powered equipment on the display.

### Description of Reference Numerals

10...information output system body; 30...electrically powered equipment; 110...processing mechanism; 130... storage mechanism; 150... output interface; 170...input interface; and 310...secondary battery.

## Claims

1. A secondary battery information output system outputting, to an output interface, prescribed information based on a result of comparison between a deterioration rate of a secondary battery, which is used by a user, at a certain time point, the deterioration rate being determined according to a time series of index values of a deterioration state of the secondary battery, and an estimated deterioration rate, which is an estimated deterioration rate in a scheduled usage period of time of the secondary battery.

2. The secondary battery information output system according to claim 1,
wherein the estimated deterioration rate is a deterioration rate below which the deterioration rate of the secondary battery should be for selling, at a desired sale price asked by the user, the secondary battery after being used until a scheduled time point determined in advance, and
the prescribed information output in a case where the deterioration rate of the secondary battery is equal to or more than the estimated deterioration rate includes information for prompting usage based on a usage method for slowing down the deterioration rate of the secondary battery, or information prompting sale of the secondary battery before the scheduled time point.

3. The secondary battery information output system according to claim 2,
wherein the deterioration rate of the secondary battery at the certain time point is determined by a first approximation curve representing a time series of the deterioration state of the secondary battery based on the time series of the index values,
the estimated deterioration rate is determined by a second approximation curve representing an estimated tendency of the progress of the deterioration state of the secondary battery with passage of time during the scheduled usage period of time, and
contents of the prescribed information are determined according to a result of comparison between a rate of change of the first approximation curve at the certain time point and a rate of change of the second approximation curve at a time point corresponding to the certain time point.

4. The secondary battery information output system according to claim 2,
wherein the secondary battery is installed in electrically powered equipment,
the electrically powered equipment is electrically powered equipment which is provided with the secondary battery and has been sold to the user under a condition that a seller of the electrically powered equipment will repurchase the electrically powered equipment at the scheduled time point, and
the prescribed information output in the case where a deterioration rate at the certain time point is equal to or more than the estimated deterioration rate includes information on an estimated price at the time of repurchasing the electrically powered equipment, which is determined according to the deterioration rate of the secondary battery at the time point.

5. The secondary battery information output system according to claim 4,
wherein the electrically powered equipment is a hybrid vehicle or an electric vehicle.
